# EUROPÄISCHE PATENTSCHRIFT

(11) **EP 2 936 559 B1**
(45) Veröffentlichungstag und Bekanntmachung des Hinweises auf die Patenterteilung: **12.08.2020**
(21) Anmeldenummer: 13802370.0
(22) Anmeldetag: 09.12.2013
(51) Int. Cl.: H01L 25/075, F21S 9/02

(54) **LED-MODUL MIT LED-CHIP GRUPPEN**
LED MODULE WITH LED CHIP GROUPS
MODULE DE LED COMPRENANT DES GROUPES DE PUCES DE LED

(30) Priorität: 20.12.2012 DE 102012223945
(43) Veröffentlichungstag der Anmeldung: 28.10.2015
(73) Patentinhaber: Tridonic GmbH & Co. KG, 6850 Dornbirn (AT)
(72) Erfinder: WIMMER, Florian, A-8380 Neumarkt a.d. Raab (AT); GUMHOLD, Jürgen, A-8380 Jennersdorf (AT)
(74) Vertreter: Rupp, Christian
(86) Internationale Anmeldenummer: PCT/EP2013/075971
(87) Internationale Veröffentlichungsnummer: WO 2014/095463

(56) Entgegenhaltungen:
- EP-A1- 2 717 338
- WO-A1-2012/165007
- DE-A1-102008 021 572
- DE-U1-202012 009 636
- US-A1- 2005 117 334
- US-A1- 2011 089 441

## Beschreibung

Die vorliegende Erfindung bezieht sich auf ein LED-Modul, eine LED-Leuchte und eine Notlichtleuchte.

LED-Module mit wenigstens einem LED-Chip werden in vielen Bereichen der Beleuchtungstechnik eingesetzt. Insbesondere über die letzten Jahre haben LED-Module in fast allen Bereichen der Beleuchtungstechnik Fuß gefasst und werden beispielsweise aufgrund ihrer Energieeffizienz zunehmend eingesetzt. Da die vergleichsweise geringe Leistungsaufnahme für einen Einsatz in vielen Bereichen positiv ist, finden LED-Module beispielsweise auch dann Anwendung, wenn die zur Verfügung stehende elektrische Leistung für einen Leuchtbetrieb begrenzt ist. Als Beispiel können hierfür Notlichtleuchten dienen, die im Falle eines Netzspannungsausfalls zur Beleuchtung eingesetzt werden.

Ein weiterer Vorteil der LED-Module ist, dass auch eine größere Anzahl an LED-Chips auf einen LED-Modul mit relativ kleinen Abmessungen angebracht werden kann. Somit lassen sich mehrere LED-Chips kombinieren und eine höhere Lichtleistung auf relativ kleinem Raum realisieren. DE 20 2012 009636 U1, US 2011/089441 A1, DE 10 2008 021572 A1, D4 US 2005/117334 A1 und WO 2012/165007 A1 offenbaren LED-Module gemäß dem Stand der Technik.

Die vorliegende Erfindung macht es sich nunmehr zur Aufgabe LED-Module z.B. für den Einsatz in LED-Leuchten, bzw. Notlichtleuchten, bereitzustellen, die eine Reduzierung der Anzahl der eingesetzten LED-Module erlaubt.

In einer Ausführungsform stellt die Erfindung ein LED-Modul gemäß dem Anspruch 1 bereit.

Der Farbkonversionsstoff kann insbesondere einen Phosphor enthalten.

Die von den LED-Chips der ersten und zweiten Gruppe emmitierte Strahlung kann Licht im sichtbaren Spektrum sein. Die LED-Chips der zweiten Gruppe können Strahlung vorzugsweise im roten Spektrum emmitieren. Die von den LED-Chips der zweiten Gruppe emmitierte Strahlung wird durch den wenigstens einen Farbkonversionsstoff in der überdeckenden Schicht nicht konvertiert. D.h., lediglich das von der ersten Gruppe emmitierte Spektrum wird in diesem Fall umgesetzt.

Die LED-Chips der ersten und der zweiten Gruppe können im Wesentlichen identisch sein.

Die Lichtleistung der zweiten Gruppe an LED-Chips kann in einem Bereich von 1%-25%, bevorzugt in einem Bereich von 5%-10%, der Lichtleistung der LED-Chips der ersten Gruppe liegen. Die Anzahl der LED-Chips der zweiten Gruppe kann 1%-25%, vorzugsweise 5%-15%, der Anzahl der LED-Chips der ersten Gruppe entsprechen.

Das LED-Modul kann wenigstens einen ersten Leiter zur Verbindung der LED-Chips der ersten Gruppe mit einem ersten Anschluss zum Verbinden der ersten Gruppe mit einer ersten elektrischen Versorgung und wenigstens einen zweiten Leiter zur Verbindung der LED-Chips der zweiten Gruppe mit einem zweiten Anschluss zum Verbinden der zweiten Gruppe mit einer zweiten elektrischen Versorgung aufweisen. Die Leiter können dabei vorzugsweise auf dem Träger angeordnet sein. Die Leiter können auch über den eigentlichen Modulträger hinausführen und so z.B. mit Leitern anderer Module verbunden werden. Die Anschlüsse können sich ebenfalls außerhalb des LED-Modul-Trägers befinden, sind aber vorzugsweise auf dem Träger angeordnet. Die Leiter können zumindest teilweise von der überdeckenden Schicht überdeckt sein.

Die Leiter können weiter zumindest teilweise auf der Seite des Trägers angeordnet sein, auf der die LED-Chips angeordnet sind. Die Leiter können aber auch zumindest teilweise auf der Seite des Trägers angeordnet sein, auf der die LED-Chips nicht angeordnet sind.

Die Anschlüsse auf dem Träger können so angeordnet sein, dass sie sich im Wesentlichen gegenüber liegen. Insbesondre können die Anschlüsse an unterschiedlichen Seiten des LED-Moduls angeordnet sein. Die Anschlüsse können auch auf unterschiedlichen Seiten des Trägers angeordnet sein, z.B. kann ein Teil der Anschlüsse auf der Trägerseite angeordnet sein, auf der sich die LED-Chips einer Gruppe befinden, während sich ein anderer Teil der Anschlüsse auf einer anderen Seite des Trägers befindet. Die Anschlüsse können im Wesentlichen parallel zueinander angeordnet sein. Die Anschlüsse können an einer Seite des LED-Moduls vorgesehen sein.

Der Träger kann eine Leiterplatte, z.B. ein einseitiges oder doppelseitiges PCB, oder einem SMD-Träger (Surface-Mounted Device-Träger) sein.

In einem Weiteren Aspekt stellt die Erfindung eine LED-Leuchte bereit, aufweisend wenigstens ein LED-Modul wie vorstehend beschrieben sowie je eine unabhängige elektrische Versorgung für jede Gruppe an LED-Chips.

Die elektrischen Versorgungen der LED-Leuchte können als Spannungsversorgungen derart ausgebildet sein, dass zur gleichen Zeit immer nur eine Gruppe an LED-Chips betrieben wird.

In noch einem Aspekt stellt die Erfindung eine LED-basierte Notlichtleuchte bereit, aufweisend wenigstens eine LED-Leuchte wie vorstehend beschrieben, wobei wenigstens eine Gruppe an LED-Chips ausgehend von einer ersten elektrischen Versorgung/Netzspannung und wenigstens eine Gruppe an LED-Chips ausgehend von einer von der elektrischen Versorgung/Netzspannung unabhängigen zweiten elektrischen Versorgung/Spannungsversorgung betrieben werden können. Es ist zu verstehen, dass statt einer elektrische Versorgung jeweils von einer Spannungsquelle oder Stromquelle aus erfolgen kann, wobei eine Gruppe ausgehend von einer Spannungsquelle und eine andere Gruppe ausgehend von einer Stromquelle versorgt werden kann. Auch kenn bei mehreren Gruppen für jede Gruppe eine elektrische Versorgung vorgesehen sein.

Die LED-basierte Notlichtleuchte kann weiter einen Energiespeicher, vorzugsweise eine Batterie oder einen Akkumulator, einen Anschluss zum Anschließen der Notlichtleuchte an eine elektrische Versorgung, insbesondere eine Versorgungsspannung oder Netzspannung, und eine Erkennungsschaltung, die dazu eingerichtet ist, eine Unterbrechung der ersten elektrischen Versorgung zu erkennen aufweisen, wobei die Notlichtleuchte dazu eingerichtet ist, wenigstens LED-Chips der ersten Gruppe wenigstens eines LED-Moduls bei Anliegen der ersten elektrischen Versorgung zu betreiben und bei Erkennung einer Unterbrechung der ersten elektrischen Versorgung durch die Erkennungsschaltung wenigstens die LED-Chips der zweiten Gruppe zu betreiben.

Die Notlichtleuchte kann die zweite Gruppe ausgehend von dem Energiespeicher betreiben.

Die Notlichtleuchte kann dazu eingerichtet sein, ein LED-Modul wie oben beschrieben und ein anderes LED-Modul zu betreiben, wobei das andere LED-Modul lediglich eine, insbesondere eine einzige, Gruppe von LED-Chips aufweist. Das Notlichtgerät kann das andere LED-Modul und/oder die LED-Chips der ersten Gruppe des LED-Moduls ausgehend von der ersten elektrischen Versorgung, z.B. bei Anliegen der Versorgungsspannung, betreiben. Die Notlichtleuchte kann die LED-Chips der zweiten Gruppe ausgehend von der zweiten elektrischen Versorgung, z.B. bei einem Ausfall der Versorgungsspannung, betreiben, und insbesondere nur die zweite Gruppe. Die LED-Chips des LED-Moduls und die LED-Chips des anderen LED-Moduls können gleich, vorzugsweise in einem gleichen vorbestimmten Raster, angeordnet sein. Die Anzahl der LED-Chips der Module kann sich im Wesentlichen entsprechen, bzw. gleich sein.

In noch einem weiteren Aspekt stellt die Erfindung eine Kombination eines LED-Modules wie vorstehend beschrieben, mit einem anderen LED-Modul bereit. Das andere LED-Modul kann lediglich eine einzige Gruppe von LED-Chips aufweisen, wobei die LED-Chips beider Module in einem gleichen vorbestimmten Raster angeordnet sein können. Die Anzahl der LED-Chips der Module kann sich im Wesentlichen entsprechen, bzw. gleich sein.

Die Kombination kann weiter mit einer Leuchte und/oder einer Notlichtleuchte, wie sie vorstehend beschrieben sind, kombiniert werden. Dabei ist zu Verstehen, dass die jeweilige Leuchte/Notlichtleuchte auch nur ein einziges LED-Modul jeder Art aufweisen kann, also insbesondere lediglich ein LED-Modul aufweisen kann, wie es vorstehend beschrieben ist.

Die Erfindung wird nun auch mit Blick auf die Figuren beschrieben. Dabei zeigt:
Fig. 1 exemplarisch ein erfindungsgemäßes LED-Modul gemäß einer ersten Ausführungsform,
Fig. 2 schematisch eine mögliche Verbindung der LED-Chips mit Leitern, die auf dem LED-Modul nach der ersten Ausführungsform angebracht sind,
Fig. 3 schematisch eine zweite Ausführungsform eines erfindungsgemäßen LED-Moduls,
Fig. 4 schematisch eine mögliche Verbindung der LED-Chips mit Leitern, die auf dem LED-Modul nach der zweiten Ausführungsform angebracht sind,
Fig. 5 schematisch eine Leuchte, insbesondere eine Notlichtleuchte.

Die vorliegende Erfindung betrifft folglich LED-Module mit mindestens zwei LED-Chips, wobei sich die auf einem LED-Modul M, M' vorhandenen LED-Chips erfindungsgemäß vorzugsweise in zwei oder mehr Gruppen G1, G2, G1', G2' gliedern lassen. Insgesamt wird das LED-Modul M, M' durch bekannte Herstellungsprozesse gefertigt. Es weist dabei beispielsweise eine Leiterplatte (z.B. PCB) als Träger oder einen SMD-Träger auf.

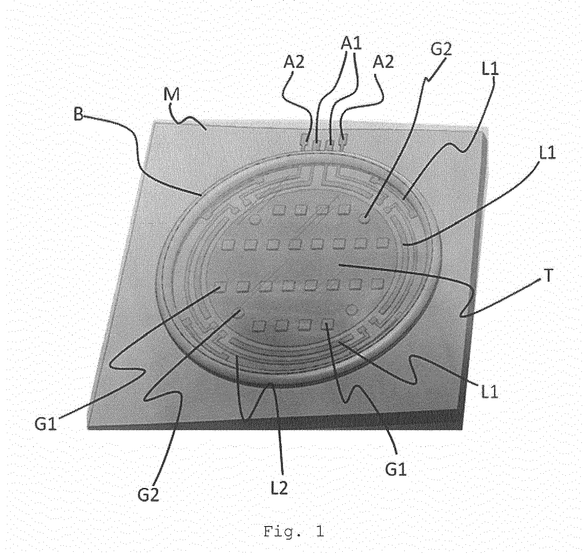

Fig. 1 zeigt ein LED-Modul M einer ersten Ausführungsform, bei dem die LED-Chips einer ersten Gruppe G1, als Quadrate und die LED-Chips einer zweiten Gruppe G2 als Kreise dargestellt sind. Weiter sind Leiter L1, L2 dargestellt, die zur Versorgung der jeweiligen LED-Gruppen G1, G2 dienen. Eine Überdeckende Schicht T ist durch eine Barriere B begrenzt. Anschlüsse A1 sind zum Anschluss der ersten Gruppe G1 mit einer ersten elektrischen Versorgung vorgesehen, während Anschlüsse A2 zum Anschluss der zweiten Gruppe G2 mit einer zweiten elektrischen Versorgung vorgesehen sind.

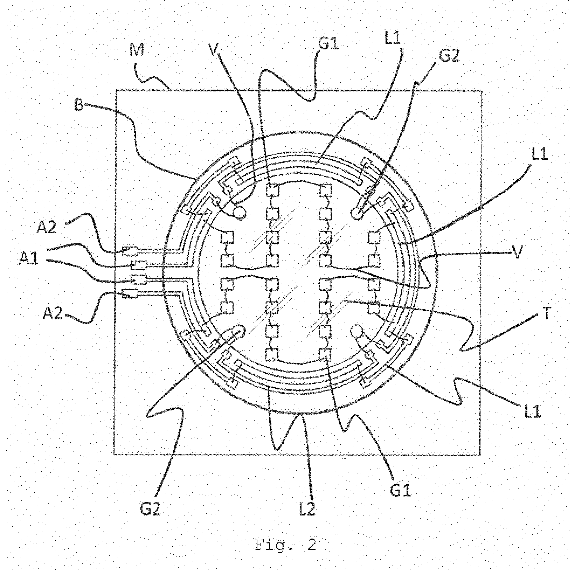

Fig. 2 zeigt dabei eine Möglichkeit, wie die LED-Chips der verschiedenen Gruppen G1, G2 des LED-Moduls M aus Fig. 1 mit den jeweiligen Leitern L1, L2 und damit mit den Anschlüssen A1, A2 für die jeweilige Gruppe G1, G2 verbunden sind. Das LED-Modul ist hierbei im Vergleich zu Fig. 1 um 90° gegen den Uhrzeigersinn gedreht dargestellt. Dabei stellen wiederum die Anschlüsse A1 die Anschlüsse für die LED-Chips für die erste Gruppe G1 dar, während die Anschlüsse A2 die Anschlüsse für die zweite LED-Chip-Gruppe G2 darstellen. Die Verbindungen zwischen Leitern L1, L2 und den LED-Chips der Gruppen G1, G2 sind mit V bezeichnet. Insbesondere kann die Verbindung der LED-Chips in einer Serienschaltung erfolgen. In dem dargestellten Beispiel sind die Anschlüsse A1, A2 für die LED-Chip-Gruppen G1, G2 an der gleichen Seite des LED-Moduls ausgeführt.

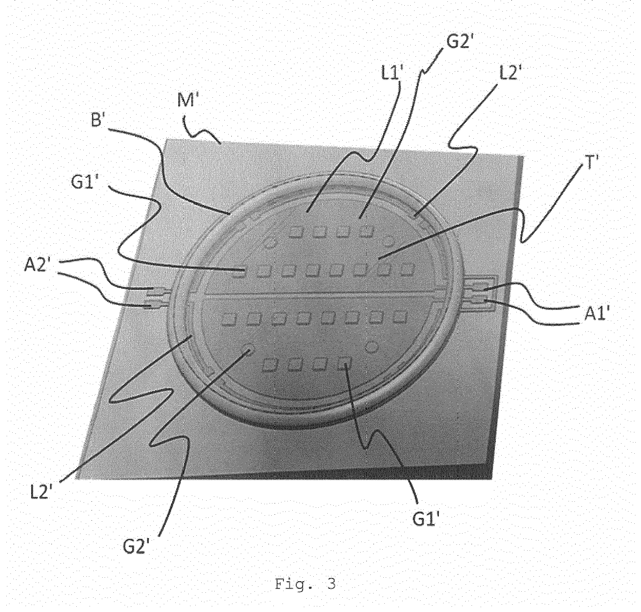

In Fig. 3 sind die Anschlüsse A1' und A2' des Moduls M' im Wesentlich parallel zu einer Modulseite hin ausgeführt. Auch hier sind zwei Gruppen G1', G2' von LED-Chips dargestellt, wobei die erste LED-Chip-Gruppe G1' beispielhaft durch Kreise und die zweite Gruppe G2' durch Quadrate dargestellt ist. Ebenfalls sind wiederum Leiter L1', L2' dargestellt, die jeweils eine LED-Gruppe G1', G2' mit den jeweiligen Anschlüssen A1', A2' verbinden. Dabei sind insbesondere die Leiter L1', L2' anders ausgeformt als in Fig. 1 und die Anschlüsse A1', A2' liegen sich nunmehr (diametral) an gegenüberliegenden Seiten des LED-Moduls M' gegenüber.

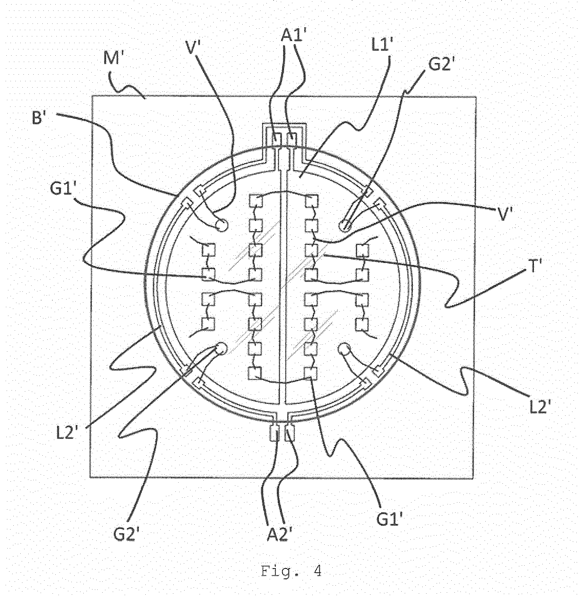

Fig. 4 zeigt wie die LED-Chips der jeweiligen Gruppe G1', G2' beispielsweise mit den Anschlüssen A1' und A2' des LED-Moduls M' aus Fig. 3 über die Leiter L1' und L2' und die Verbindungen V' verbunden werden können. Das LED-Modul ist hierbei im Vergleich zu Fig. 3 um 90° gegen den Uhrzeigersinn gedreht dargestellt.

In den Figuren sind der Übersichtlichkeit wegen nicht alle gleichartigen Bestandteile mit Bezugszeichen versehen.

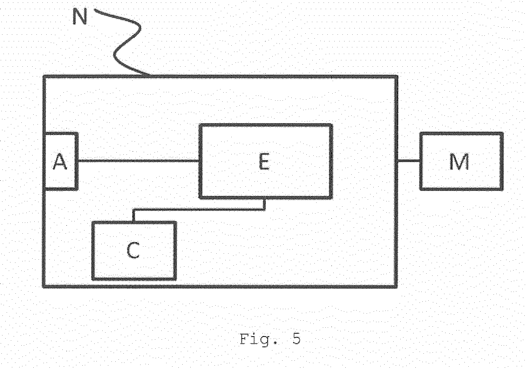

Fig. 5 zeigt schematisch eine Leuchte, insbesondere eine Notlichtleuchte N. Die Notlichtleuchte N ist über einen Anschluss A mit einer ersten elektrischen Versorgung, z.B. einer Versorgungs- oder Netzspannung, verbindbar. Die Notlichtleuchte weist weiter einen Energiespeicher C auf, der eine zweite elektrische Versorgung darstellt. Die Notlichtleuchte N weist zudem eine Erkennungsschaltung E auf, die eine Unterbrechung der ersten elektrischen Versorgung erkennen kann. Die Notlichtleuchte N betreibt weiter ein Modul M (oder M'), das, abhängig von dem von der Erkennungsschaltung E erkannten Zustand der ersten elektrischen Versorgung, entweder ausgehend von der ersten elektrischen Versorgung oder von der zweiten elektrischen Versorgung versorgt wird, hier z.B. von dem Energiespeicher C.

Dabei ist das erfindungsgemäße LED-Modul M, M' insbesondere so ausgestaltet, dass jede Gruppe G1, G2, G1', G2' an LED-Chips separat ausgehend von wenigstens einer elektrischen Spannungs-/Stromversorgung betrieben werden kann. In den Figuren sind die LED-Chips einer ersten Gruppe G1, G1' schematisch als Kreise dargestellt, während die LED-Chips einer zweiten Gruppe G2, G2' als Quadrate dargestellt sind.

Es ist jedoch zu verstehen, dass sich die LED-Chips in ihrer baulichen Gestaltung tatsächlich nicht unterscheiden müssen, bzw. andere Formen aufweisen können. Als LED-Chips können insbesondere kostengünstige SMD-LED-Chips eingesetzt werden.

Die erfindungsgemäßen LED-Module M, M' weisen dabei eine erste Gruppe G1, G1' von LED-Chips und eine zweite Gruppe G2, G2' von LED-Chips auf, die unter einer einheitlichen überdeckenden Schicht T, T', beispielsweise einer einheitlichen Vergussmasse, angeordnet sind. Die überdeckende Schicht T, T' weist dabei insbesondere einen Farbkonversionsstoff, beispielsweise wenigstens einen Phosphor auf, der zumindest teilweise die von den LED-Chips abgegebene Strahlung konvertiert. Dabei kann vorgesehen sein, dass der Farbkonversionsstoff die von den LED-Chips einer oder mehrerer Gruppen G1, G2, G1', G2' abgegebene Strahlung, und in einem Beispiel nicht gemäß der Erfindung die von allen Gruppen G1, G2, G1', G2' Abgegebene, in eine Strahlung umsetzt, die in einem anderen Spektrum liegt, als die von den LED-Chips abgegebene Strahlung. Weiter kann vorgesehen sein, dass der Farbkonversionsstoff aus mehreren Bestandteilen, z. B. mehreren Phosphoren besteht. In einem Beispiel nicht gemäß der Erfindung konvertiert der Farbkonversionsstoff die Strahlung aller LED-Chips, die von der überdeckenden Schicht T, T' überdeckt sind.

Es kann vorgesehen sein, dass eine erste Gruppe G1, G1' an LED-Chips nur betrieben wird, wenn eine andere Gruppe G2, G2' an LED-Chips nicht betrieben wird. Dies ist insbesondere dadurch möglich, dass sich die verschiedene Gruppen G1, G2, G1', G2' zugehörigen LED-Chips von unabhängigen elektrischen Versorgungen her versorgen lassen. So ist es beispielsweise möglich, eine LED-Chip-Gruppe ausgehend von einer ersten elektrischen Versorgung, z.B. Wechselspannungs/-stromquelle zu versorgen, eine andere LED-Chip-Gruppe ausgehend von zweiten elektrischen Versorgung, z.B. einer Gleichspannungs/- stromquelle.

Vorzugsweise emittieren die insbesondere zwei Gruppen G1, G2, G1', G2' an LED-Chips Strahlung in einem Spektrum, insbesondere einem einzigen Spektrum, dass dann teilweise oder vollständig durch den in der überdeckenden Schicht T, T' enthaltenen Farbkonversionsstoff konvertiert wird. Selbstverständlich kann vorgesehen sein, dass die abgegebene Strahlung, z.B. im sichtbaren Spektrum, jedes LED-Chips durch den Farbkonversionsstoff konvertiert wird. Jedoch ist es auch möglich, dass der Farbkonversionsstoff lediglich die Strahlung einer Gruppe G1, G1'/G2, G2' oder bestimmter LED-Chips konvertiert.

Unter Konversion durch den Farbkonversionsstoff ist hierbei insbesondere die Umsetzung einer Strahlung einer dominanten Wellenlänge in die Strahlung einer anderen dominanten Wellenlänge zu verstehen.

Die überdeckende Schicht T, T' kann durch bekannte Verfahren über/auf den LED-Chips angebracht werden. Beispielsweise kann die überdeckende Schicht in einem "Dam-and-Fill"-Verfahren oder durch ein "Dispensen" z.B. als Kugelkopf/Globe-Tops über/auf den LED-Chips angebracht werden.

Unter einem "Dam-and-Fill"-Verfahren ist dabei ein Verfahren zu verstehen, bei dem um die LED-Chips eine Barriere B, B', insbesondere auf dem LED-Modul M, M', geformt ist, die das Abfließen einer aufgebrachten überdeckenden Schicht, bzw. einer Vergussmasse, über die Barriere B, B' hinaus verhindert.

Das so gestaltete LED-Modul M, M' kann nun insbesondere in LED-Leuchten eingesetzt werden, die über unabhängige elektrische Versorgungen für jede LED-Chip-Gruppe G1, G2, G1', G2' versorgt sind. So können mit einem einzigen LED-Modul M, M' zwei verschiedene Beleuchtungsmodi eingestellt werden.

Dies ist beispielsweise in Situationen vorteilhaft, in denen Licht eines Spektrums in einer bestimmten Situation abgegeben werden soll, während in einer anderen Situation Licht eines anderen Spektrums abgegeben werden soll. Auch kann durch die gezielte Ansteuerung verschiedener Gruppen G1, G2, G1', G2' die von dem LED-Modul M, M' abgegebene Lichtleistung variiert werden. So ist es z. B. denkbar, dass die erfindungsgemäßen LED-Module M, M' in Fahrzeugen, beispielsweise Flugzeugen oder Zügen zum Einsatz kommen, bei denen an einem Sitzplatz beispielsweise eine Lesebeleuchtung oder eine Ruhebeleuchtung bereitgestellt werden soll. Hier können eine größere Anzahl von LED-Chips in einer ersten Gruppe G1, G1' gegliedert sein, die für die Normalbeleuchtung angesteuert wird, während eine relativ dazu kleinere Anzahl von LED-Chips in einer zweiten Gruppe G2, G2' gegliedert sein kann, die dann selektiv angesteuert wird, wenn ein Ruhebetrieb/Lesebeleuchtungsbetrieb bereitgestellt werden soll, beispielsweise auf Interaktion eines Nutzers hin.

Weiter bietet sich auch der Einsatz in einer Notlichtleuchte N an (s. Fig. 5), die beispielsweise bei einem Ausfall einer Netzspannung von einem Normalbetrieb in einen Notlichtbetrieb wechselt. Hier können durch das erfindungsgemäße LED-Modul M, M' die Herstellungskosten gesenkt werden, da nunmehr lediglich eine LED-Modulart verbaut werden muss. Die Notlichtleuchte N kann somit im Normallichtbetrieb eine erste Gruppe G1, G1' von LED-Chips des LED-Moduls M, M' ansteuern, während im Notlichtbetrieb eine zweite LED-Chip-Gruppe G2, G2' des gleichen Moduls M, M' angesteuert wird. Beispielsweise kann also im Notlichtbetrieb die zweite Gruppe G2, G2' von LED-Chips ausgehend von einem Energiespeicher C (beispielsweise einer Batterie und/oder einem Akkumulator) im Notlichtbetrieb vorzugsweise mit einer DC-Spannung versorgt werden. Im Normallichtbetrieb erfolgt die Versorgung des LED-Moduls ausgehend von einem Anschluss A mit einer Versorgungsspannung, insbesondere einer Netz-/Wechselspannung.

Die Lichtleistung der zweiten LED-Chip-Gruppe G2, G2', z.B. einer Notlicht-LED-Chip-Gruppe, kann dabei vorzugsweise in einem Bereich von 1% bis 25%, weiter bevorzugt in einem Bereich von 5% bis 10%, der Lichtleistung der ersten LED-Chip-Gruppe G1, G1', z.B. einer Normallicht-LED-Chip-Gruppe, liegen.

Insgesamt können die LED-Chips des LED-Moduls M, M' auf verschiedene Gruppen verteilt sein. Vorzugsweise kann jedoch eine Reduzierung der abgegebenen Lichtleistung dadurch erreicht werden, dass in einer Gruppe mehr LED-Chips gegliedert sind als in einer anderen LED-Gruppe. Bei zwei Gruppen G1, G2, G1', G2' wird beispielsweise eine Reduzierung der Lichtleistung dadurch erreicht, dass zwar die LED-Chips beider Gruppen G1, G2, G1', G2' im Wesentlichen identisch sind, d.h. zumindest in der gleichen Farbe, bzw. im gleichen Spektrum emittieren, jedoch die Anzahl der LED-Chips in der ersten Gruppe G1, G1' nur 1% bis 25%, bzw. vorzugsweise 5% bis 15%, der Anzahl der LED-Chips der zweiten Gruppe G2, G2' beträgt. Hierdurch kann beispielsweise auch die Reduzierung der Lichtleistung auf die Notlichtbetriebs-Leistung realisiert werden, indem in einem Notlichtbetrieb von der ersten Gruppe G1, G1' auf die zweite Gruppe G2, G2' der LED-Chips umgeschaltet wird und diese dann durch die Notlichtleuchte N betrieben wird.

Hierdurch kann die von dem LED-Modul M, M' aufgenommene Leistung natürlich reduziert werden, wobei die Verringerung der Anzahl der zu betreibenden LED-Chips bereits zu der Reduzierung beiträgt. Durch die Wahl verschiedener LED-Chips für jede Gruppe kann eine weitere Reduzierung der benötigten Betriebsleistung erfolgen. So können z.B. in der zweiten Gruppe energieeffizientere LED-Chips eingesetzt werden, als in der ersten Gruppe.

Insgesamt ist es selbstverständlich möglich mehrere Gruppen vorzusehen und somit eine Staffelung der abgegebenen Lichtleistung zu erreichen. Beispielsweise könnten bei drei LED-Gruppen zunächst die LED-Chips aller drei Gruppen im Normallichtbetrieb betrieben werden, während verschiedene Modi gewählt werden können, um einzelne LED-Gruppen zu de-/aktivieren. Wird dabei der Betrieb einer LED-Gruppe mit "1" bezeichnet und das Abschalten einer LED-Gruppe mit "0", so sind bereits bei drei LED-Gruppen acht Betriebsmodi möglich: 1, 1, 1; 1, 1, 0; 1, 0, 1; 1, 0, 0; 0, 1, 1; 0, 1, 0; 0, 0, 1; und 0, 0, 0.

Diese Betriebsmodi können z.B. auch abhängig von der zur Verfügung stehenden Leistung oder durch Zeitablauf gewählt werden. So kann vorgesehen sein, dass ein Betriebsmodus gewählt wird, wenn mehr Leistung aus einem Energiespeicher (z.B. dem Energiespeicher C) abgerufen werden kann/soll, währen ein anderer Betriebsmodus gewählt wird, wenn ein bestimmter Schwellenwert erreicht wird. Entsprechend können mehrere Schwellenwerte vorgesehen sein, auf die hin ein/die Betriebsmodus/-modi gewählt wird/werden. Alternativ oder zusätzlich kann im zeitlichen Abstand ab Eintritt eines Ereignisses, z.B. nach Erkennung durch die Erkennungschaltung E eines Netzspannungsausfalls, ein Betriebsmodus gewählt werden. So können verschiedene Betriebsmodi in festen oder variablen zeitlichen Abständen von dem Ereignis gewählt werden.

Grundsätzlich können die LED-Gruppen G1, G2, G1', G2' aber auch in unterschiedlichen Farben emittieren, wobei gemäß einem erfindungsgemäßen Ausführungsbeispiel die Strahlung/Licht insbesondere von LED-Chips der zweiten LED-Chip-Gruppe G2, G2' in einem anderen, beispielsweise im roten Spektrum liegen kann, das durch einen eingesetzten Farbkonversionsstoff, insbesondere einem verwendeten Phosphor, in der überdeckenden Schicht T, T' nicht konvertiert wird, als die von den LED-Chips der ersten Gruppe G1, G1' abgegebene Strahlung.

Selbstverständlich kann das erfindungsgemäße LED-Modul M, M' einzeln aber auch in Kombination mit anderen LED-Modulen verwendet und angeordnet werden. Dabei ist insbesondere die Kombination des erfindungsgemäßen LED-Moduls M, M' mit einem LED-Modul interessant, das insgesamt die gleiche Anzahl von LED-Chips in gleicher Anordnung, beispielsweise in einem gleichen Raster, aufweist. Dies ist insbesondere dann sinnvoll, wenn in einem ersten Betriebsmodus, z.B. einem Normallichtmodus, mehrere LED-Module eine gleiche Lichtleistung abgeben sollen, während in einem anderen Betriebsmodus, z.B. einem Notlichtbetriebsmodus, lediglich die für diesen Modus ausgelegten erfindungsgemäßen LED-Module M, M' bzw. deren LED-Chips der zweiten Gruppe G2, G2' betrieben werden sollen. Dabei kann insbesondere bei Notlichtleuchten N der Energiebedarf stark reduziert werden, wodurch sich die mögliche Betriebsdauer der Notlichtleuchten N im Notlichtbetriebsmodus stark verlängert. Insbesondere wird der Energiespeicher C dann weniger stark belastet.

Weiter ist auch die Kombination des erfindungsgemäßen LED-Moduls M, M' mit einer Notlichtleuchte N vorgesehen, die dann beispielsweise noch mit weiteren LED-Modulen, insbesondere mit einer gleichen Anzahl und gleichen Anordnung von LED-Chips kombiniert werden kann.

Vorzugsweise sind die erfindungsgemäßen LED-Module M, M' so ausgestaltet, dass im Vergleich zu anderen LED-Modulen mit mehreren LED-Chips keine Abweichung in der Anordnung der LED-Chips auf dem LED-Modul und/oder der abgegebenen Lichtleistung im Normalbetrieb besteht.

Es ist selbstverständlich zu verstehen, dass insbesondere beim Vorliegen mehrerer LED-Chip-Gruppen andere Leiterführungen und Anschlussanordnungen vorgesehen sein können. Wichtig ist hierbei lediglich, dass jede LED-Gruppe über eine separate Spannungsversorgung versorgt werden kann.

## Patentansprüche

1. LED-Modul (M, M'), aufweisend:
- einen Träger,
- eine auf dem Träger angeordnete erste Gruppe (G1, G1') und eine zweite Gruppe (G2, G2') an LED-Chips, optional noch eine oder mehrere weitere Gruppen an LED-Chips, und
- eine sämtliche LED-Chips einheitliche überdeckende Schicht (T, T'), die wenigstens einen Farbkonversionsstoff enthält, der das Spektrum der LEDs einer oder sämtlicher Gruppen in ein Spektrum mit anderer dominanter Wellenlänge umsetzt, wobei:
- jede Gruppe (G1, G2, G1', G2') wenigstens einen, bevorzugt mehrere LED-Chips umfasst,
- die LED-Chips einer Gruppe (G1, G2, G1', G2') vorzugsweise in Serie geschaltet sind und ausgehend von derselben elektrischen Versorgung versorgbar sind, und
- die LED-Chips unterschiedlicher Gruppen (G1, G2, G1', G2') unabhängig voneinander ausgehend von unterschiedlichen elektrischen Versorgungen versorgbar sind; wobei
- die von den LED-Chips der zweiten Gruppe (G2, G2') emmitierte Strahlung durch den wenigstens einen Farbkonversionsstoff in der überdeckenden Schicht (T, T') nicht konvertiert wird, **dadurch gekennzeichnet, dass**
- die überdeckende Schicht einheitlich ist, und
- die überdeckende Schicht (T, T') in einem "Dam-and-Fill"-Verfahren über/auf den LED-Chips angebracht ist, wobei in dem "Dam-and-Fill"-Verfahren um die LED-Chips eine Barriere (B, B') geformt ist, die das Abfließen der überdeckenden Schicht (T, T') über die Barriere (B, B') hinaus verhindert.

2. LED-Modul (M, M') nach Anspruch 1, wobei der Farbkonversionsstoff insbesondere einen Phosphor enthält.

3. LED-Modul (M, M') nach Anspruch 1 oder 2, wobei die von den LED-Chips der ersten und zweiten Gruppe (G1, G2, G1', G2') emmitierte Strahlung Licht im sichtbaren Spektrum ist.

4. LED-Modul (M, M') nach einem der vorigen Ansprüche, wobei die LED-Chips der zweiten Gruppe (G2, G2') Strahlung vorzugsweise im roten Spektrum emmitieren.

5. LED-Modul (M, M') nach einem der vorigen Ansprüche, wobei die LED-Chips der ersten und der zweiten Gruppe (G1, G2, G1', G2') im Wesentlichen identisch sind.

6. LED-Modul (M, M') nach einem der vorigen Ansprüche, wobei die Lichtleistung der zweiten Gruppe (G2, G2') an LED-Chips in einem Bereich von 1%-25%, bevorzugt in einem Bereich von 5%-10%, der Lichtleistung der LED-Chips der ersten Gruppe (G1, G1') liegt und/oder wobei die Anzahl der LED-Chips der zweiten Gruppe (G2, G2') 1%-25%, vorzugsweise 5%-15%, der Anzahl der LED-Chips der ersten Gruppe (G1, G1') entspricht.

7. LED-Modul (M, M') nach einem der vorigen Ansprüche, wobei das LED-Modul (M, M') wenigstens einen ersten Leiter (L1, L1') zur Verbindung der LED-Chips der ersten Gruppe (G1, G1') mit einem Anschluss (A1, A1') zum Verbinden der ersten Gruppe (G1, G1') mit einer ersten elektrischen Versorgung und wenigstens einen zweiten Leiter (L2, L2') zur Verbindung der LED-Chips der zweiten Gruppe (G2, G2') mit einem anderen Anschluss (A2, A2') zum Verbinden der zweiten Gruppe (G2, G2') mit einer zweiten elektrischen Versorgung aufweist, wobei die Leiter (L1, L2, L1', L2') auf dem Träger angeordnet sind.

8. LED-Modul (M, M') nach einem der vorigen Ansprüche, wobei die Leiter (L1, L2, L1', L2') zumindest teilweise auf der Seite des Trägers angeordnet sind, auf der die LED-Chips angeordnet sind und/oder wobei die Leiter (L1, L2, L1', L2') zumindest teilweise auf der Seite des Trägers angeordnet sind, auf der die LED-Chips nicht angeordnet sind.

9. LED-Modul (M, M') nach einem der vorigen Ansprüche, wobei die Anschlüsse (A1, A2, A1', A2') auf dem Träger so angeordnet sind, dass sie sich gegenüber liegen und/oder zumindest teilweise im Wesentlichen parallel zueinander angeordnet sind, und/oder wobei Anschlüsse (A1, A2, A1', A2') an einer Modulseite oder sich gegenüberliegenden Modulseiten vorgesehen sind.

10. LED-Modul (M, M') nach einem der vorigen Ansprüche, wobei die Leiter (L1, L2, L1', L2') zumindest teilweise nicht von der überdeckende Schicht (T, T') bedeckt sind.

11. LED-Modul (M, M') nach einem der vorgehenden Ansprüche, wobei der Träger eine Leiterplatte oder einem SMD-Träger ist.

12. LED-Leuchte, aufweisend wenigstens ein LED-Modul (M, M') nach einem der vorhergehenden Ansprüche sowie je eine unabhängige elektrische Versorgung für jede Gruppe (G1, G2, G1', G2') an LED-Chips.

13. LED-Leuchte nach Anspruch 12, bei der die elektrischen Versorgungen als Spannungs-/Stromversorgungen derart ausgebildet sind, und dass zur gleichen Zeit immer nur eine Gruppe (G1, G2, G1', G2') an LED-Chips betrieben wird.

14. LED-basierte Notlichtleuchte (N), aufweisend wenigstens eine LED-Leuchte nach einem der Ansprüche 12 oder 13, wobei wenigstens eine Gruppe (G1, G2, G1', G2') an LED-Chips ausgehend von einer ersten elektrischen Versorgung und wenigstens eine Gruppe (G1, G2, G1', G2') an LED-Chips ausgehend von einer von der ersten elektrischen Versorgung unabhängigen zweiten elektrischen Versorgung betreibbar ist.

15. LED-basierte Notlichtleuchte (N) nach Anspruch 14, aufweisend einen Energiespeicher (C), vorzugsweise eine Batterie oder einen Akkumulator, einen Anschluss (A) zum Anschließen der Notlichtleuchte (N) an eine erste elektrische Versorgung, insbesondere eine Netzspannung, und eine Erkennungsschaltung (E), die dazu eingerichtet ist, eine Unterbrechung der ersten elektrischen Versorgung zu erkennen, wobei die Notlichtleuchte (N) dazu eingerichtet ist, wenigstens die LED-Chips einer Gruppe (G1, G1') wenigstens eines LED-Moduls bei Anliegen der ersten elektrischen Versorgung zu betreiben und bei Erkennung einer Unterbrechung der ersten elektrischen Versorgung durch die Erkennungsschaltung (E) wenigstens die LED-Chips einer anderen Gruppe (G2, G2') zu betreiben.

16. LED-basierte Notlichtleuchte (N) nach Anspruch 14 oder 15, wobei die Notlichtleuchte (N) die andere Gruppe (G2, G2') ausgehend von einer zweiten elektrischen Versorgung, insbesondere ausgehend von dem Energiespeicher (C), betreibt.

17. LED-basierte Notlichtleuchte (N) nach einem der vorgehenden Ansprüche, wobei die Notlichtleuchte (N) dazu eingerichtet ist, ein LED-Modul (M, M') nach Anspruch 1 und ein anderes LED-Modul zu betreiben, wobei das andere LED-Modul lediglich eine Gruppe von LED-Chips aufweist, und wobei das Notlichtgerät die LED-Chips der einen Gruppe (G1, G1') des LED-Moduls (M, M') und/oder das andere LED-Modul bei Anliegen der ersten elektrischen Versorgung betreibt, und/oder lediglich die LED-Chips der anderen Gruppe (G2, G2') bei einem Ausfall der ersten elektrischen Versorgung betreibt, und wobei die LED-Chips des LED-Moduls (M, M') und die LED-Chips des anderen LED-Moduls gleich, vorzugsweise in einem gleichen vorbestimmten Raster, angeordnet sind und/oder wobei sich die Anzahl der LED-Chips der LED-Module entspricht.

18. Kombination eines LED-Modules (M, M') nach Anspruch 1, mit einem anderen LED-Modul, das lediglich eine einzige Gruppe von LED-Chips aufweist, wobei die LED-Chips beider Module in einem gleichen vorbestimmten Raster angeordnet sind, und/oder sich in ihrer Anzahl im Wesentlichen entsprechen.

19. Kombination nach Anspruch 18, weiter kombiniert mit/in einer Leuchte nach Anspruch 12 und/oder einer Notlichtleuchte (N) nach Anspruch 15.

## Claims

1. LED module (M, M') comprising:
- a carrier,
- a first group (G1, G1') and a second group (G2, G2') of LED chips, arranged on the carrier, optionally one or more further groups of LED chips, and
- a layer (T, T') which uniformly covers all of the LED chips and contains at least one color conversion substance that converts the spectrum of the LEDs of one or all of the groups into a spectrum having a different dominant wavelength, wherein:
- each group (G1, G2, G1', G2') comprises at least one, preferably a plurality of LED chips,
- the LED chips of a group (G1, G2, G1', G2') are preferably connected in series and can be supplied from the same electrical supply, and
- the LED chips of different groups (G1, G2, G1', G2') can be supplied independently of one another from different electrical supplies; wherein
- the radiation emitted by the LED chips of the second group (G2, G2') is not converted by the at least one color conversion substance in the covering layer (T, T'), **characterized in that**
- the covering layer is uniform, and
- the covering layer (T, T') is applied over/on the LED chips in a dam and fill process, wherein, in the dam and fill process, a barrier (B, B') is formed around the LED chips which prevents the covering layer (T, T') from flowing away beyond the barrier (B, B').

2. LED module (M, M') according to Claim 1, wherein the color conversion substance in particular contains a phosphor.

3. LED module (M, M') according to Claim 1 or 2, wherein the radiation emitted by the LED chips of the first and second group (G1, G2, G1', G2') is light in the visible spectrum.

4. LED module (M, M') according to any one of the preceding claims, wherein
the LED chips of the second group (G2, G2') preferably emit radiation in the red spectrum.

5. LED module (M, M') according to any one of the preceding claims, wherein the LED chips of the first and second group (G1, G2, G1', G2') are substantially identical.

6. LED module (M, M') according to any one of the preceding claims, wherein the light output of the second group (G2, G2') of LED chips is in a range of 1%-25%, preferably 5%-10%, of the light output of the LED chips of the first group (G1, G1') and/or wherein the number of LED chips of the second group (G2, G2') corresponds to 1%-25%, preferably 5%-15%, of the number of LED chips of the first group (G1, G1').

7. LED module (M, M') according to any one of the preceding claims, wherein the LED module (M, M') comprises at least one first conductor (L1, L1') for connecting the LED chips of the first group (G1, G1') to a terminal (A1, A1') for connecting the first group (G1, G1') to a first electrical supply and at least one second conductor (L2, L2') for connecting the LED chips of the second group (G2, G2') to another terminal (A2, A2') for connecting the second group (G2, G2') to a second electrical supply, wherein the conductors (L1, L2, L1', L2') are arranged on the carrier.

8. LED module (M, M') according to any one of the preceding claims, wherein the conductors (L1, L2, L1', L2') are arranged at least partly on the side of the carrier on which the LED chips are arranged, and/or wherein the conductors (L1, L2, L1', L2') are arranged at least partly on the side of the carrier on which the LED chips are not arranged.

9. LED module (M, M') according to any one of the preceding claims, wherein the terminals (A1, A2, A1', A2') are arranged on the carrier such that they are opposite one another and/or are arranged at least partly substantially parallel to one another, and/or wherein terminals (A1, A2, A1', A2') are provided on one module side or on opposite module sides.

10. LED module (M, M') according to any one of the preceding claims, wherein the conductors (L1, L2, L1', L2') are at least partly not covered by the covering layer (T, T').

11. LED module (M, M') according to any one of the preceding claims, wherein the carrier is a circuit board or a SMD carrier.

12. LED lamp, comprising at least one LED module (M, M') according to any one of the preceding claims and a respective independent electrical supply for each group (G1, G2, G1', G2') of LED chips.

13. LED lamp according to Claim 12, in which the electrical supplies are configured as voltage/current supplies such that only one group (G1, G2, G1', G2') of LED chips is operated at a time.

14. LED-based emergency lighting lamp (N), comprising at least one LED lamp according to any one of Claims 12 or 13, wherein at least one group (G1, G2, G1', G2') of LED chips can be operated from a first electrical supply and at least one group (G1, G2, G1', G2') of LED chips can be operated from a second electrical supply that is independent of the first electrical supply.

15. LED-based emergency lighting lamp (N) according to Claim 14, comprising an energy store (C), preferably a battery or a rechargeable battery, a terminal (A) for connecting the emergency lighting lamp (N) to a first electrical supply, in particular a mains voltage, and a detection circuit (E) which is configured to detect an interruption of the first electrical supply, wherein the emergency lighting lamp (N) is configured to operate at least the LED chips of one group (G1, G1') of at least one LED module when the first electrical supply is present and to operate at least the LED chips of another group (G2, G2') when an interruption of the first electrical supply is detected by the detection circuit (E).

16. LED-based emergency lighting lamp (N) according to Claim 14 or 15, wherein the emergency lighting lamp (N) operates the other group (G2, G2') from a second electrical supply, in particular from the energy store (C).

17. LED-based emergency lighting lamp (N) according to any one of the preceding claims, wherein the emergency lighting lamp (N) is configured to operate one LED module (M, M') according to Claim 1 and another LED module, wherein the other LED module comprises only one group of LED chips, and wherein the emergency lighting unit operates the LED chips of the one group (G1, G1') of the LED module (M, M') and/or the other LED module when the first electrical supply is present, and/or, in the event of a failure of the first electrical supply, operates only the LED chips of the other group (G2, G2'), and wherein the LED chips of the LED module (M, M') and the LED chips of the other LED module are arranged identically, preferably in an identical predetermined grid, and/or wherein the number of LED chips of the LED modules are the same.

18. Combination of an LED module (M, M') according to Claim 1 with another LED module that comprises only a single group of LED chips, wherein the LED chips of the two modules are arranged in an identical predetermined grid, and/or the number of LED chips of the LED modules is substantially the same.

19. Combination according to Claim 18, further combined with/in a lamp according to Claim 12 and/or an emergency lighting lamp (N) according to Claim 15.

## Revendications

1. Module LED (M, M'), présentant :
- un support,
- un premier groupe (G1, G1') et un deuxième groupe (G2, G2') de puces LED disposés sur le support, éventuellement un ou plusieurs autres groupes de puces LED, et
- une couche de recouvrement (T, T') unitaire recouvrant toutes les puces LED et contenant au moins une substance de conversion de couleur transposant le spectre des LED d'un ou de tous les groupes en un spectre à longueur d'onde dominante différente, étant entendu que :
- chaque groupe (G1, G2, G1', G2') comprend au moins une et de préférence plusieurs puces LED,
- les puces LED d'un groupe (G1, G2, G1', G2') sont de préférence connectées en série et peuvent être alimentées par la même alimentation électrique, et
- les puces LED de différents groupes (G1, G2, G1', G2') peuvent être alimentées indépendamment les unes des autres par différentes alimentations électriques ; en sachant que
- le rayonnement émis par les puces LED du deuxième groupe (G2, G2') n'est pas converti par la substance de conversion de couleur présente dans la couche de recouvrement (T, T'), **caractérisé en ce que**
- la couche de recouvrement est unitaire, et
- la couche de recouvrement (T, T') est appliquée au-dessus/sur les puces LED selon un procédé d'encapsulation « dam-and-fill » dans lequel une barrière (B, B') est formée autour des puces LED afin d'empêcher l'écoulement de la couche de recouvrement (T, T') au-delà de ladite barrière (B, B').

2. Module LED (M, M') selon la revendication 1, dans lequel la substance de conversion de couleur contient notamment un luminophore.

3. Module LED (M, M') selon la revendication 1 ou 2, dans lequel le rayonnement émis par les puces LED des premier et deuxième groupes (G1, G2, G1', G2') est de la lumière du spectre visible.

4. Module LED (M, M') selon l'une des revendications précédentes, dans lequel
les puces LED du deuxième groupe (G2, G2') émettent de préférence un rayonnement dans le spectre rouge.

5. Module LED (M, M') selon l'une des revendications précédentes, dans lequel les puces LED des premier et deuxième groupes (G1, G2, G1', G2') sont sensiblement identiques.

6. Module LED (M, M') selon l'une des revendications précédentes, dans lequel la puissance lumineuse du deuxième groupe (G2, G2') de puces LED se situe dans la plage de 1 % à 25 %, de préférence dans la plage de 5 % à 10 % de la puissance lumineuse des puces LED du premier groupe (G1, G1') et/ou dans lequel le nombre de puces LED du deuxième groupe (G2, G2') correspond à 1 % à 25 %, de préférence 5 % à 15 % du nombre de puces LED du premier groupe (G1, G1').

7. Module LED (M, M') selon l'une des revendications précédentes, dans lequel le module LED (M, M') présente au moins un premier conducteur (L1, L1') permettant de relier les puces LED du premier groupe (G1, G1') à une borne (A1, A1') destinée à relier le premier groupe (G1, G1') à une première alimentation électrique, et au moins un deuxième conducteur (L2, L2') permettant de relier les puces LED du deuxième groupe (G2, G2') à une autre borne (A2, A2') destinée à relier le deuxième groupe (G2, G2') à une deuxième alimentation électrique, lesdits conducteurs (L1, L2, L1', L2') étant disposés sur le support.

8. Module LED (M, M') selon l'une des revendications précédentes, dans lequel les conducteurs (L1, L2, L1', L2') sont disposés au moins partiellement sur le côté du support sur lequel les puces LED sont disposées et/ou dans lequel les conducteurs (L1, L2, L1', L2') sont disposés au moins partiellement sur le côté du support sur lequel les puces LED ne sont pas disposées.

9. Module LED (M, M') selon l'une des revendications précédentes, dans lequel les bornes (A1, A2, A1', A2') sont disposées sur le support de manière à être en vis-à-vis et/ou au moins partiellement sensiblement parallèles entre elles et/ou dans lequel les bornes (A1, A2, A1', A2') sont prévues sur un même côté du module ou sur des côtés opposés du module.

10. Module LED (M, M') selon l'une des revendications précédentes, dans lequel les conducteurs (L1, L2, L1', L2'), au moins en partie, ne sont pas recouverts par la couche de recouvrement (T, T').

11. Module LED (M, M') selon l'une des revendications précédentes, dans lequel le support est une carte de circuit imprimé ou un support CMS.

12. Luminaire LED, présentant au moins un module LED (M, M') selon l'une des revendications précédentes, ainsi qu'une alimentation électrique indépendante pour chaque groupe (G1, G2, G1', G2') de puces LED.

13. Luminaire LED selon la revendication 12, dans lequel les alimentations électriques sont réalisées sous la forme d'alimentations en tension/intensité permettant de n'exploiter qu'un seul groupe (G1, G2, G1', G2') de puces LED à la fois.

14. Luminaire de secours à LED (N) présentant au moins une LED selon l'une des revendications 12 et 13, et dans lequel au moins un groupe (G1, G2, G1', G2') de puces LED peut être exploité à partir d'une première alimentation électrique et au moins un groupe (G1, G2, G1', G2') de puces LED peut être exploité à partir d'une deuxième alimentation électrique indépendante de la première alimentation électrique.

15. Luminaire de secours à LED (N) selon la revendication 14, présentant une réserve d'énergie (C), de préférence une pile ou un accumulateur, une borne (A) permettant de connecter le luminaire de secours (N) à une première alimentation électrique, notamment à la tension du réseau, et un circuit de détection (E) conçu pour détecter une coupure de la première alimentation électrique, ledit luminaire de secours (N) étant conçu pour exploiter au moins les puces LED d'un groupe (G1, G1') d'au moins un module LED lorsque la première alimentation électrique est active et pour exploiter au moins les puces LED d'un autre groupe (G2, G2') lorsque le circuit de détection (E) détecte une coupure de la première alimentation électrique.

16. Luminaire de secours à LED (N) selon la revendication 14 ou 15, dans lequel le luminaire de secours (N) exploite ledit autre groupe (G2, G2') à partir d'une deuxième alimentation électrique, notamment à partir de la réserve d'énergie (C).

17. Luminaire de secours à LED (N) selon l'une des revendications précédentes, dans lequel le luminaire de secours (N) est adapté pour exploiter un module LED (M, M') selon la revendication 1 ainsi qu'un autre module LED, ledit autre module LED ne présentant qu'un seul groupe de puces LED, ledit luminaire de secours exploitant les puces LED dudit un groupe (G1, G1') du module LED (M, M') et/ou exploitant l'autre module LED lorsque la première alimentation électrique est active, et/ou exploitant uniquement les puces LED de l'autre groupe (G2, G2') en cas de défaillance de la première alimentation électrique, et lesdites puces LED du module LED (M, M') et lesdites puces LED de l'autre module LED étant disposées de façon identique, de préférence selon une même grille prédéterminée et/ou les modules LED ont un même nombre de puces LED.

18. Combinaison d'un module LED (M, M') selon la revendication 1 et d'un autre module LED ne comprenant qu'un seul groupe de puces LED, les puces LED des deux modules étant disposées selon une même grille prédéterminée et/ou sont en nombre sensiblement égal.

19. Combinaison selon la revendication 18, combinée en outre avec/dans un luminaire selon la revendication 12 et/ou un luminaire de secours (N) selon la revendication 15.
